Europäisches Patentamt

European Patent Office

Office européen des brevets

(11) Veröffentlichungsnummer: **0 348 708**
**A2**

## (12) EUROPÄISCHE PATENTANMELDUNG

(21) Anmeldenummer: 89110420.0

(51) Int. Cl.⁴: **H03M 1/34**

(22) Anmeldetag: 08.06.89

(30) Priorität: 27.06.88 DE 3821639

(43) Veröffentlichungstag der Anmeldung:
03.01.90 Patentblatt 90/01

(84) Benannte Vertragsstaaten:
AT DE FR GB IT NL

(71) Anmelder: **Siemens Aktiengesellschaft**
**Wittelsbacherplatz 2**
**D-8000 München 2(DE)**

(72) Erfinder: **Bayati, Abutorab, Dr.**
**Schlehenweg 26**
**D-7500 Karlsruhe 31(DE)**

(54) **Analog-Digital-Umsetzer für ein Oszilloskop.**

(57) Die Erfindung betrifft einen Analog-Digital-Umsetzer, der einen von einem Zähltakt gesteuerten
Zähler aufweist. Um den Analog-Digital-Umsetzer bei
schnellen digitalen Oszilloskopen vorteilhaft einsetzen zu können, zählt ein Vorwärts-Rückwärts-Zähler
mit seinem Zählerstand kontinuierlich innerhalb des
Meßbereichs um die Nullspannung (OV), und es ist
ein Komparator (K) vorhanden, der bei Gleichheit
des analogen Eingangssignals (Ug) und eines dem
Zählerstand entsprechenden Signals die Ausgabe
des Zählerstandes als Digitalsignal veranlaßt.

Die Erfindung ist in der elektronischen Meßtechnik für analoge elektrische Größen anwendbar.

FIG 1

## Analog-Digital-Umsetzer für ein Oszilloskop

### Technisches Gebiet

Die Erfindung betrifft einen Analog-Digital-Umsetzer mit einem von einem Zähltakt gesteuerten Vorwärts-Rückwärts-Zähler, einer Schaltung zur Erzeugung einer dem Zählerstand des Vorwärts-Rückwärts-Zählers entsprechenden Analogspannung und einem digitalen Ausgangssignal an den parallelen Zählausgängen des Vorwärts-Rückwärts-Zählers, welcher für ein digitales Oszilloskop verwendbar ist.

### Stand der Technik

Analog-Digital-Umsetzer mit den Merkmalen des Oberbegriffs des Anspruchs 1 sind beispielsweise aus Tietze/Schenk "Halbleiter-Schaltungstechnik", fünfte überarbeitete Auflage, Springer-Verlag 1980, Seiten 658 und 659 bekannt. Bei den digitalen Oszilloskopen, die nach einem Randomsampling-Verfahren arbeiten, werden die Eingangssignale oft mit Signalen abgetastet, deren Frequenz wesentlich tiefer liegt. Um schnelle Eingangssignale darstellen zu können, müssen hierbei die Abtastpunkte dementsprechend sehr kurz gehalten werden, was zu einer komplizierten und sehr aufwendigen Sample and Hold-Schaltung führt.

### Darstellung der Erfindung

Der Erfindung liegt die Aufgabe zugrunde, eine Anordnung zu schaffen, bei der ein schnelles digitales Oszilloskop optimal mit einem Analog-Digital-Umsetzer versehen ist.

Zur Lösung dieser Aufgabe weist ein Analog-Digital-Umsetzer der eingangs genannten Art die Merkmale des Kennzeichens des Anspruchs 1 auf.

Vorteilhafte Ausführungsformen sind in den Unteransprüchen angegeben.

### Kurze Beschreibung der Zeichnung

Die Erfindung wird anhand der Figuren erläutert, wobei

Figur 1 ein erstes Ausführungsbeispiel eines Analog-Digital-Umsetzers für ein digitales Oszilloskop,

Figur 2 ein zugehöriges Spannungsdiagramm,

Figur 3 ein zweites Ausführungsbeispiel eines Analog-Digital-Umsetzers für ein digitales Oszilloskop und

Figur 4 ein zugehöriges Spannungsdiagramm zeigt.

### Bester Weg zur Ausführung der Erfindung

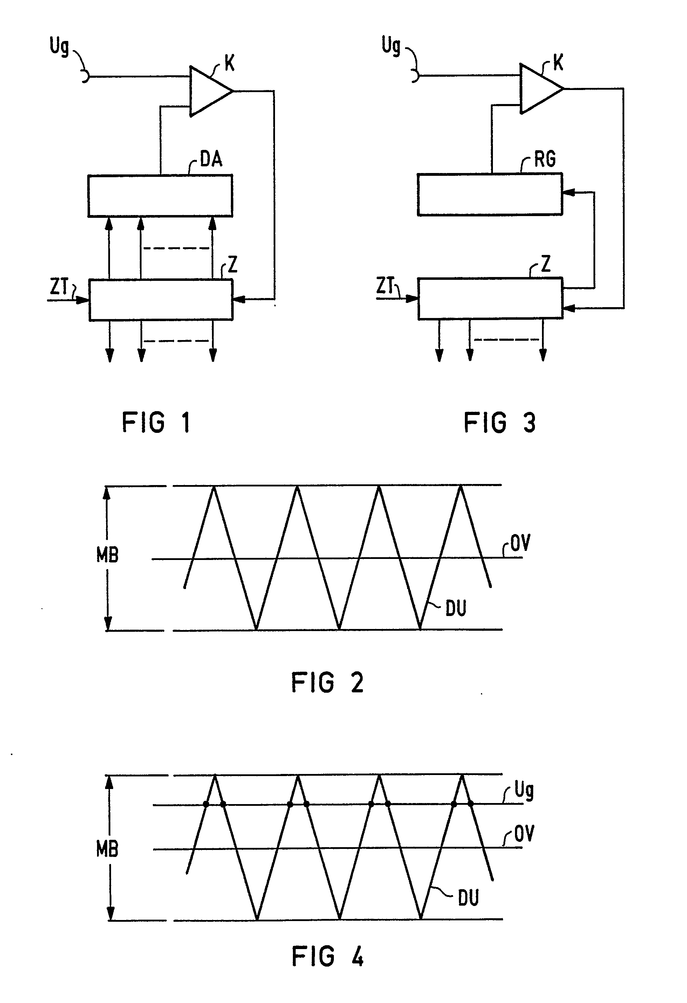

Es wird in Figur 1 und Figur 3 jeweils ein Analog-Digital-Umsetzer beschrieben, der für die Anwendung in digitalen Oszilloskopen besonders gut geeignet ist. Der Analog-Digital-Umsetzer besteht aus einem Vor- und Rückwärtszähler 2, einem Komparator K und entweder einem Digital-Analog-Umsetzer DA (Figur 1) oder einem Rampengenerator RG.

Der Zähler Z, der fortlaufend Impulse eines Zähltaktes ZT zählt, bewirkt, daß am Ausgang des Digital-Analog-Umsetzers DA und des Rampengenerators RG eine Dreieckspannung DU steht, wie sie jeweils in Figur 2 (zu Figur 1) und in Figur 4 (zu Figur 3) dargestellt ist. Der Analog-Digital-Umsetzer wird so dimensioniert, daß bei Zählerlänge die Dreieckspannung DU innerhalb des Meßbereichs MB um die Nullspannung OV hin- und herpendelt. Dabei ist die Auflösung des Analog-Digital-Umsetzers durch die Zählerlänge gegeben. Bei der Ausführung mit einem Digital-Analog-Umsetzer nach der Figur 1 läuft die Dreieckspannung DU ähnlich, aber nicht kontinuierlich, sondern treppenmäßig.

Beim Anlegen einer Eingangsspannung Ug werden sich diese und die Dreieckspannung DU fortlaufend treffen. Den Zählerinhalten an den Treffpunkten, die durch den Komparator K signalisiert werden, entsprechen die Momentangrößen der Eingangsspannung Ug an diesen Treffpunkten (Verschlüsselungspunkten). Dieser Vorgang wird beispielhaft für eine bestimmte Eingangsgleichspannung Ug in Figur 4 dargestellt.

Durch den Einsatz von Zählern Z, die im GHz-Bereich zählen können, und sehr schnellen Komparatoren K, deren Verzögerungszeit- und Jitterkonstante im ps-Gebiet liegen, können Analog-Digital-Umsetzer realisiert werden, die sehr schnell abtasten und damit Eingangssignale bis zu 100 MHz und mehr erfassen können. Durch Flankenpolarität des Komparators H können außerdem Treffpunkte auf steigender bzw. fallender Flanke der Dreieckspannung DU festgestellt werden. Danach kann je nach Polarität durch Subtraktion bzw. Addition eine konstante Zahl mit Zählerinhalten erreicht werden, so daß der Verzögerungszeiteinfluß des Komparators K kompensiert wird. Dies kann auch analog erreicht werden, indem der Komparator K eine entsprechende Offsetspannung bekommt, die nur während einer der beiden Zählrichtungen zugeschaltet wird.

Gewerbliche Anwendbarkeit

Die Erfindung ist in der elektronischen Meßtechnik für analoge elektrische Größen anwendbar.

## Ansprüche

1. Analog-Digital-Umsetzer mit
- einem von einem Zähltakt gesteuerten Vorwärts-Rückwärts-Zähler (Z),
- einer Schaltung zur Erzeugung einer dem Zählerstand des Vorwärts-Rückwärts-Zählers (Z) entsprechenden Analogspannung und
- einem digitalen Ausgangssignal an den parallelen Zählausgängen des Vorwärts-Rückwärts-Zählers (Z),
**dadurch gekennzeichnet, daß**
- der Vorwärts-Rückwärts-Zähler (Z) mit seinem Zählerstand kontinuierlich innerhalb des Meßbereichs um die Nullspannung (OV) hin- und herpendelt,
- ein Komparator (K) vorhanden ist, an dessen erstem Eingang die umzusetzende Analoggröße (Ug) und an dessen zweitem Eingang die dem Zählerstand entsprechende Analoggröße ansteht,
- bei Gleichheit der Analogspannungen an den Eingängen des Komparators (K) ein Ausgangssignal des Komparators (K) den Vorwärts-Rückwärts-Zähler (Z) zur Ausgabe seines Zählerstandes als Digitalsignal veranlaßt und daß
- die Analoggröße (Ug) am Eingang das Eingangssignal eines digitalen Oszilloskops ist, welches nach dem Randomsampling-Verfahren arbeitet, und das digitale Ausgangssignal im Oszilloskop zur Darstellung der Analoggröße ausgewertet wird.

2. Analog-Digital-Umsetzer nach Anspruch 1, **dadurch gekennzeichnet, daß**
- die Schaltung zur Erzeugung einer dem Zählerstand des Vorwärts-Rückwärts-Zählers (Z) entsprechenden Analogspannung ein Digital-Analog-Wandler (DA) ist.

3. Analog-Digital-Umsetzer nach Anspruch 1, **dadurch gekennzeichnet, daß**
- die Schaltung zur Erzeugung einer dem Zählerstand des Vorwärts-Rückwärts-Zählers (2) entsprechenden Analogspannung ein Rampengenerator (RG) ist.

P 4433

FIG 1

FIG 3

FIG 2

FIG 4